# EUROPEAN PATENT APPLICATION

(11) **EP 2 372 783 A1**
(43) Date of publication of application: **05.10.2011**
(21) Application number: 09835072.1
(22) Date of filing: 26.12.2009
(51) Int. Cl.: H01L 31/042, H01L 21/312, H01L 31/04

(54) **PHOTOELECTRIC CONVERSION MODULE**

(30) Priority: 26.12.2008 JP 2008333983; 27.04.2009 JP 2009107904
(71) Applicant: Kyocera Corporation, Kyoto-shi Kyoto 612-8501 (JP)
(72) Inventor: MATSUSHIMA, Norihiko, Higashiomi-shi Shiga 527-8555 (JP); SUZUKI, Masato, Higashiomi-shi Shiga 527-8555 (JP); NIIRA, Koichiro, Higashiomi-shi Shiga 527-8555 (JP)
(74) Representative: Keck, Stephan
(86) International application number: PCT/JP2009/071702
(87) International publication number: WO 2010/074276

(57) **Abstract**

A photoelectric conversion module X1 comprises a photoelectric conversion element D1 and a protective member 9. The photoelectric conversion element D1 comprises a photoelectric conversion layer with a first main surface and a light-transmitting conductive layer 6 located on the first main surface. The protective member 9 on the light-transmitting conductive layer 6 comprising an ethylene vinyl acetate resin and an acid acceptor.

## Description

### TECHNICAL FIELD

The present invention relates to a photoelectric conversion module.

### BACKGROUND ART

There are various types of photoelectric conversion elements, such as solar cell elements, used for photovoltaic power generation. A chalcopyrite-based or amorphous-silicon-based thin film type photoelectric conversion element, as typified by a CIS type, easily allows an increase in the area of a photoelectric conversion module with a relatively low cost, and therefore research and development thereof have been promoted.

In such a thin film type photoelectric conversion element, normally, transparent conductive films are often used as electrodes at the light-receiving surface side (front surface side) and the non-light-receiving surface side (back surface side). A photoelectric conversion module adopting such a photoelectric conversion element has a structure in which a sealing material containing an ethylene vinyl acetate (hereinafter also referred to as EVA) resin as a main component is provided between the photoelectric conversion element and a surface member (covering member) made of glass for example, to thereby seal the photoelectric conversion element (see Patent Document 1).

However, the fact is known that, if such a photoelectric conversion module in which the photoelectric conversion element is sealed with the sealing material is used for a long time of ten years or more under warm and humid environments, weather environments, snowing environments, or the like, the sealing material containing the EVA resin as a main component is gradually hydrolyzed to cause an acid material such as acetic acid. This acid material may deteriorate the transparent conductive film, and consequently increase the resistance value of the transparent conductive film or reduce the light transmittance of the transparent conductive film. Thus, a photoelectric conversion module having an improved reliability under humid environments is demanded.

### PRIOR-ART DOCUMENTS

### PATENT DOCUMENTS

Patent Document 1: Japanese Patent Application Laid-Open No. 2007-123725

### SUMMARY OF THE INVENTION

A photoelectric conversion module according to the present invention includes: a photoelectric conversion element comprising at least one photoelectric conversion layer with a first main surface and a light-transmitting conductive layer located on the first main surface; and a protective member on the light-transmitting conductive layer comprising an ethylene vinyl acetate resin and an acid acceptor.

### BRIEF DESCRIPTION OF THE DRAWINGS

FIG. 1 is a cross-sectional view showing a part corresponding to a photoelectric conversion element of a photoelectric conversion module according to a first embodiment of the present invention.
FIG. 2 is a cross-sectional view showing a part corresponding to a photoelectric conversion element of a photoelectric conversion module according to a second embodiment of the present invention.
FIG. 3 is a cross-sectional view of the photoelectric conversion module according to the first embodiment of the present invention.
FIG. 4 is a cross-sectional view of the photoelectric conversion module according to the second embodiment of the present invention.
FIG. 5 is a cross-sectional view of a photoelectric conversion module according to a third embodiment of the present invention.
FIG. 6(a) is a cross-sectional view of a photoelectric conversion module according to a fourth embodiment of the present invention, and (b) is a perspective view showing a part corresponding to a covering member of the photoelectric conversion module of (a).
FIG. 7 is a cross-sectional view of a photoelectric conversion module according to a fifth embodiment of the present invention.

### EMBODIMENT FOR CARRYING OUT THE INVENTION

Hereinafter, embodiments of the present invention will be described with reference to the drawings.

### <Photoelectric Conversion Element>

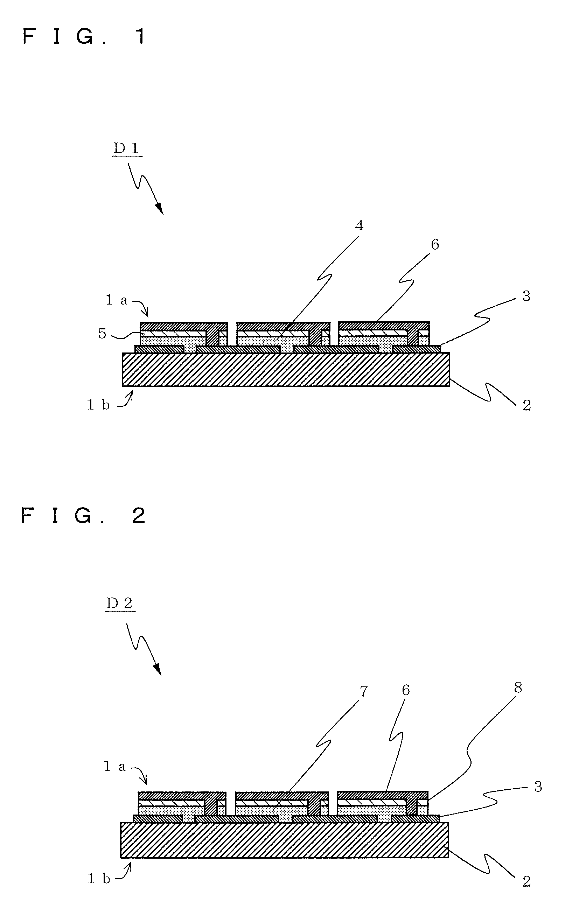

Firstly, a description will be given of a photoelectric conversion element used in a photoelectric conversion module according to a first embodiment of the present invention. As shown in FIG. 1, a photoelectric conversion element D1 used in the photoelectric conversion module according to the first embodiment includes a substrate 2, an electrode 3, a chalcopyrite-based compound semiconductor layer 4, a buffer layer 5, and a light-transmitting conductive layer 6. In this embodiment, the chalcopyrite-based compound semiconductor layer 4 and the buffer layer 5 form a photoelectric conversion layer. The photoelectric conversion layer is not limited to this one, and other materials may be used.

The substrate 2 has a function of supporting the electrode 3, the chalcopyrite-based compound semiconductor layer 4, the buffer layer 5, and the light-transmitting conductive layer 6. No particular limitation is put on the material of the substrate 2. Examples of the material of the substrate 2 include a blue plate glass (soda-lime glass) having a thickness of approximately 1 to 3 mm, a plastic having a heat resistance such as a polyimide resin, and a metal foil include of stainless, titanium, or the like having a thickness of approximately 100 to 200 µm.

The electrode 3 has a function of carrying a charge caused by light absorption of the chalcopyrite-based compound semiconductor layer 4 which will be described later. Examples of the material of the electrode 3 include metals such as molybdenum, titanium, or tantalum, and layered structures of these metals. It suffices that the thickness of the electrode 3 is approximately 1 to 2 µm, from the viewpoint of maintaining the charge carrying function and making it unlikely to increase in the resistance value excessively. Forming the electrode 3 with a material having a light transmissivity such as SnO₂ can increase a photoelectric conversion efficiency, because a light can be efficiently incident on the chalcopyrite-based compound semiconductor layer 4 serving as a light absorbing layer from a back surface side.

The chalcopyrite-based compound semiconductor layer 4 has a function as a light absorbing layer, and the conductivity type thereof is a p-type semiconductor. Examples of the material of the chalcopyrite-based compound semiconductor layer 4 include copper indium diselenide (CuInSe₂), copper indium-gallium diselenide (CuInGaSe2), copper indium-gallium selenide-sulfide (CuInGaSeS), copper indium-gallium disulfide (CuInGaS₂), or copper indium-gallium diselenide (CuInGaSe₂) whose surface layer is formed of a thin film of copper indium-gallium selenide-sulfide (CuInGaSeS). It suffices that the thickness of the chalcopyrite-based compound semiconductor layer 4 is approximately 1 to 3 µm.

The buffer layer 5 is provided between the chalcopyrite-based compound semiconductor layer 4 and the light-transmitting conductive layer 6, and has a function as a buffer material. The buffer layer 5 is a semiconductor layer whose conductivity type is n-type. The buffer layer 5 can reduce an influence given on the light-transmitting conductive layer 6 by an uneven shape of a surface of the chalcopyrite-based compound semiconductor layer 4. Additionally, in a case where the light-transmitting conductive layer 6 is formed by a sputtering method, the buffer layer 5 can reduce an influence of the sputtering method on the chalcopyrite-based compound semiconductor layer 4. Examples of the material of the buffer layer 5 include cadmium sulfide (CdS), indium sulfide (InS), and zinc sulfide (ZnS). It suffices that the thickness of the buffer layer 5 is approximately 5 to 200 nm.

The photoelectric conversion layer is not limited thereto. Other materials may be used for a junction structure of the chalcopyrite-based compound semiconductor layer 4 and the buffer layer 5. The junction structure may be a homo junction between a semiconductor layer of one conductivity type and a semiconductor layer of the other conductivity type, or a hetero junction between a semiconductor layer of one conductivity type and a semiconductor layer of the other conductivity type.

The light-transmitting conductive layer 6 is provided at a first main surface side 1a (upper surface side in FIG. 1) of the photoelectric conversion element D1, and has a function of carrying a charge caused at a pn junction part due to the light absorption of the chalcopyrite-based compound semiconductor layer 4. The light-transmitting conductive layer 6 is a semiconductor layer whose conductivity type is n-type. In the photoelectric conversion element D1 according to this embodiment, the charge is caused at the pn junction part between the chalcopyrite-based compound semiconductor layer 4 whose conductivity type is mainly p-type and the buffer layer 5 and the light-transmitting conductive layer 6 whose conductivity type are mainly n-type. Examples of the material of the light-transmitting conductive layer 6 include zinc oxide (ZnO), zinc oxide compounds containing aluminum, boron, gallium, indium, fluorine or the like, and indium tin oxide (ITO) or tin oxide (SnO₂). Particularly, zinc oxide and tin-containing indium oxide tin are preferably in view of the light transmittance and the resistance value. It suffices that the thickness of the light-transmitting conductive layer 6 is approximately 0.05 to 2 µm.

Next, an exemplary method for manufacturing the photoelectric conversion element D1 will be described.

Firstly, a film of the electrode 3 is formed substantially throughout a surface of the washed glass substrate 2 by a sputtering method or the like. Then, dividing grooves are formed at a desired position in the electrode 3 by using a YAG laser or the like, for the patterning of the electrode 3. Then, a film of the chalcopyrite-based compound semiconductor layer 4 is formed on the patterned electrode 3 by using a sputtering method, a vapor-deposition process, a printing process, or the like. Then, a film of the buffer layer 5 is formed on the chalcopyrite-based compound semiconductor layer 4 by a solution-growth process (CBD method) or the like. Then, the chalcopyrite-based compound semiconductor layer 4 and the buffer layer 5 are patterned by a mechanical scribing process or the like. Finally, a film of the light-transmitting conductive layer 6 is formed on the buffer layer 5 by a sputtering method, a metal organic chemical vapor deposition (MOCVD method) process, or the like. If needed, the light-transmitting conductive layer 6 is patterned by a mechanical scribing process. Thus, the photoelectric conversion element D1 is manufactured. In this embodiment, for reducing a resistance, a silver paste or the like may be printed on the transparent conductive film to form a grid electrode.

Next, a photoelectric conversion element used in a photoelectric conversion module according to a second embodiment of the present invention will be described. As shown in FIG. 2, a photoelectric conversion element D2 used in the photoelectric conversion module according to the second embodiment is different from the photoelectric conversion element D1 used in the photoelectric conversion module according to the first embodiment described above, in that, instead of the chalcopyrite-based compound semiconductor layer 4 and the buffer layer 5, an amorphous silicon semiconductor junction layer 7 and a microcrystalline silicon semiconductor junction layer 8 are provided as the photoelectric conversion layer. In this embodiment, except for the amorphous silicon semiconductor layer 7 and the microcrystalline silicon semiconductor layer 8, the same members as those of the photoelectric conversion element D1 described above may be used. In this embodiment, the electrode 3 may be made of not only the above-mentioned materials but also the same material as that of the light-transmitting conductive layer 6.

The amorphous silicon semiconductor junction layer 7 has a function of absorbing a light to produce a carrier and generating a photocurrent by a built-in electric field. The amorphous silicon semiconductor layer 7 is formed on the electrode 3, and includes three layers of a p-type hydrogenated amorphous silicon carbide (a-SiC:H) layer having a thickness of approximately 10 to 20 nm, an i-type hydrogenated amorphous silicon (a-Si:H) layer having a thickness of approximately 200 to 300 nm, and an n-type hydrogenated amorphous silicon layer having a thickness of approximately 20 to 50 nm.

The microcrystalline silicon semiconductor junction layer 8 has a function of absorbing a light to produce a carrier and generating a photocurrent by a built-in electric field. The microcrystalline silicon semiconductor layer 8 is formed on the amorphous silicon semiconductor layer 7, and includes three layers of a p-type microcrystalline silicon layer (µc-Si:H) layer having a thickness of approximately 10 to 50 nm, an i-type microcrystalline silicon layer having a thickness of approximately 1500 to 3500 nm, and an n-type microcrystalline silicon layer having a thickness of approximately 10 to 50 nm.

In this embodiment, the light-transmitting conductive layer 6 is formed on the microcrystalline silicon semiconductor layer 8. If a silver (Ag) layer having a thickness of approximately100 to 300 nm is provided on the light-transmitting conductive layer 6, a light incident from a second main surface 1b side of the photoelectric conversion element D2 can be reflected by the silver layer. As a result, such a configuration enables the light to be incident on the amorphous silicon semiconductor junction layer 7 and the microcrystalline silicon semiconductor junction layer 8 again, and thus the photoelectric conversion efficiency can be improved.

The amorphous silicon semiconductor junction layer 7 is arranged at the light-incident side of the microcrystalline silicon semiconductor junction layer 8. Therefore, the above-described structure is based on the assumption that a light is incident from the lower side (second main surface 1b side) in FIG. 2. In a case where a light is incident from the upper side (first main surface 1a side), the reference numeral 8 indicates the amorphous silicon semiconductor junction layer, and the reference numeral 7 indicates the microcrystalline silicon semiconductor junction layer.

The photoelectric conversion layer is not limited thereto. For example, only the amorphous silicon semiconductor layer 7 suffices without providing the microcrystalline silicon semiconductor junction layer 8. Only the microcrystalline silicon semiconductor junction layer 8 also suffices without providing the amorphous silicon semiconductor layer 7.

Next, an exemplary method for manufacturing the photoelectric conversion element D2 will be described.

Firstly, a film of the electrode 3 is formed substantially throughout one main surface of the substrate 2 by a thermal CVD method, a sputtering method, or the like. Then, separating grooves are formed in the electrode 3 by using a YAG laser device, for the patterning of the electrode 3, to separate the electrode 3 into strips each having a width of approximately 5 to 20 mm.

Then, a film of the amorphous silicon semiconductor layer 7 is formed on the substrate 2 and the electrode 3 by a plasma CVD method or the like. In this film formation step, the temperature of the substrate 2 is set at approximately 150 to 250 degrees C, and then the film formation steps are sequentially performed. Firstly, for example, a p-type hydrogenated amorphous silicon carbide film is formed on the substrate 2 and the electrode 3 by using a monosilane gas (SiH₄), a hydrogen gas (H₂), a methane gas (CH₄), and a diborane gas (B₂H₆). Then, an i-type hydrogenated amorphous silicon layer film is formed on the p-type hydrogenated amorphous silicon carbide layer by using, for example, a monosilane gas (SiH₄) and a hydrogen gas (H₂). Finally, an n-type hydrogenated amorphous silicon film is formed on the i-type hydrogenated amorphous silicon layer by using a monosilane gas (SiH₄), a hydrogen gas (H₂), and a phosphine gas (PH₃). Thus, the amorphous silicon semiconductor layer 7 is obtained. In a case of the hydrogenated amorphous silicon, a preferable flow rate ratio (H₂/SiH₄) of the hydrogen gas (H₂) relative to the monosilane gas (SiH₄) is approximately 3 to 10.

Then, a film of the microcrystalline silicon semiconductor layer 8 is formed on the amorphous silicon semiconductor layer 7 by a plasma CVD method. In this film formation step, the temperature of the substrate 2 is set at approximately 150 to 250 degrees C, and then the film formation steps are sequentially performed. Firstly, a p-type microcrystalline silicon layer film is formed by using a monosilane gas (SiH₄), a hydrogen gas (H₂), and a diborane gas (B₂H₆). Then, an i-type microcrystalline silicon layer film is formed on the p-type microcrystalline silicon layer by using a monosilane gas (SiH₄) and a hydrogen gas (H₂). Finally, an n-type microcrystalline silicon layer film is formed by using a monosilane gas (SiH₄), a hydrogen gas (H₂), and a phosphine gas (PH₃). Thus, the microcrystalline silicon semiconductor layer 8 is obtained. In a case of the microcrystalline silicon, a preferable flow rate ratio (H₂/SiH₄) of the hydrogen gas (H₂) relative to the monosilane gas (SiH₄) is approximately 10 to 300.

If an n-type microcrystalline silicon layer having a thickness of approximately 10 to 50 nm is formed between the amorphous silicon semiconductor layer 7 and the microcrystalline silicon semiconductor layer 8 described above, better reverse junction characteristics can be obtained, which is preferable in view of the improvement in the photoelectric conversion efficiency.

Then, separating grooves are formed in the amorphous silicon semiconductor layer 7 and the microcrystalline silicon semiconductor layer 8 by using a YAG laser or the like, for the patterning thereof.

Then, by a sputtering method or the like, a film of zinc oxide (ZnO) to serve as the light-transmitting conductive layer 6, and a film of silver (Ag) if needed, is formed at a temperature of approximately 50 to 220 degrees C which causes a small damage of the amorphous silicon semiconductor layer 7 and the microcrystalline silicon semiconductor layer 8. Then, a laser beam is emitted from the substrate 2 side by using a YAG laser or the like, thereby forming separating grooves in the light-transmitting conductive layer 6, the silver layer, the microcrystalline silicon semiconductor layer 8, and the amorphous silicon semiconductor layer 7 that have been formed, for the patterning thereof. Thus, the integrated photoelectric conversion element D2 having a plurality of photoelectric conversion cells electrically connected in series with one another is obtained.

### <Photoelectric Conversion Module>

Next, the photoelectric conversion module according to the first embodiment of the present invention will be described with reference to the drawings.

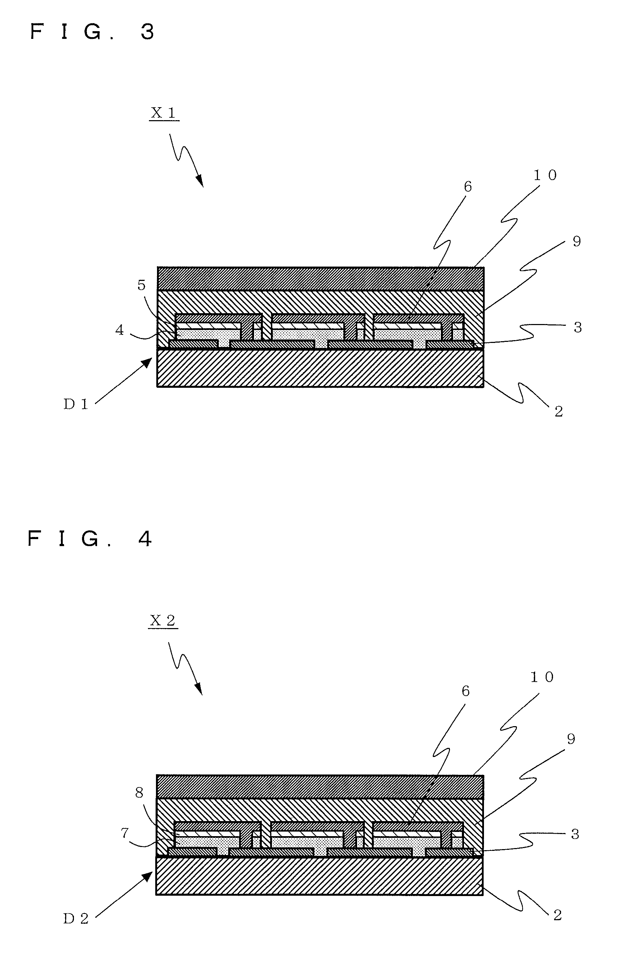

FIG. 3 is a cross-sectional view showing a photoelectric conversion module X1 according to the first embodiment of the present invention. The photoelectric conversion module X1 includes the photoelectric conversion element D1, a protective member 9, and a covering member 10.

The protective member 9 mainly has a function of protecting the photoelectric conversion element D1. Additionally, the protective member 9 has a function of bonding the photoelectric conversion element D1 and the covering member 10 to each other. The protective member 9 contains, as a main component, a copolymerized ethylene vinyl acetate (EVA) resin (hereinafter, ethylene vinyl acetate resin may also be referred to as EVA), and contains an acid acceptor as an accessory component. The acid acceptor is 0.5 or more parts by mass and 5 or less parts by mass per 100 parts by mass of the ethylene vinyl acetate resin. The protective member 9 additionally contains a crosslinking agent for EVA, and if needed, may contain a crosslinking co-agent, an adhesion promoter, and the like. Examples of the crosslinking agent include polyfunctional compounds such as triallyl isocyanurate.

The acid acceptor is a material exhibiting the alkaline property neutralizable with a material (acid material) exhibiting the acidic property, or a material capable of absorbing an acid material. Examples of the material of the acid acceptor include oxides such as magnesium oxide (MgO) and lead oxide (Pb₃O₄), hydroxides such as magnesium hydroxide (Mg(OH)₂) and calcium hydroxide (Ca(OH)₂), carbonic acid compounds such as calcium carbonate (CaCO₃), and mixtures of these materials. Particularly, magnesium hydroxide is preferable in view of reducing a defect in the light-transmitting conductive layer 6 (such as an increase in the resistance value and a deterioration in the adhesivity to the buffer layer). Preferably, the acid acceptor is in the shape of particles having an average particle diameter of 0.1 µm or more and 4 µm or less. An acid acceptor having this average particle diameter can suppress an aggregation of the particles, thus allowing an easy dispersion of the particles over a wide range. Thus, a deterioration in an acid accepting function can be reduced.

In this embodiment, thus, the acid acceptor is added to the protective member 9 containing EVA. Therefore, even if, for example, the photoelectric conversion module is installed in an outdoor environment for long period and as a result the EVA is hydrolyzed to cause acetic acid which is an acid material, the acetic acid can be absorbed or neutralized by the acid acceptor. In this embodiment, therefore, a deterioration of the light-transmitting conductive layer 6 due to the acid material can be reduced, to improve the reliability. Particularly, if the light-transmitting conductive layer 6 is made of zinc oxide which has a relatively low humidity resistance, an increase in the resistance (a sheet resistance and a contact resistance) of the light-transmitting conductive layer 6 and a decrease in the adhesivity to the buffer layer 5 can be easily reduced. In this embodiment, a main object is to reduce an influence of the acid material on the light-transmitting conductive layer 6. Here, if the photoelectric conversion element D1 is structured such that a member other than the light-transmitting conductive layer 6, such as the electrode 3, the chalcopyrite-based compound semiconductor layer 4, or the buffer layer 5, is in contact with the protective member 9, an influence such as the deterioration given on the member other than the light-transmitting conductive layer 6 by the acid material can be reduced.

The covering member 10 mainly covers the light-transmitting conductive layer 6, and has a function of maintaining the photoelectric conversion element D1 for a long time. The material of such a covering member 10 is not particularly limited, as long as it has a high strength and a good light transmittance. For example, a white tempered glass having a thickness of approximately 3 to 5 mm is preferable.

Next, an exemplary method for manufacturing the photoelectric conversion module X1 according to the first embodiment of this embodiment will be described. A resin material serving as a precursor of the protective member 9 is arranged on an upper surface of the light-transmitting conductive layer 6 of the photoelectric conversion element D1 manufactured in the above-described method. Then, the covering member 10 is placed on the resin material, to prepare a laminated body including the photoelectric conversion element, the resin material, and the covering member. Then, the laminated body is set in a laminating device (laminator), and heated under pressure at a temperature of approximately 100 to 150 degrees C under a reduced pressure of approximately 50 to 150 Pa for approximately 15 to 60 minutes. Thereby, the laminated body is integrated. Finally, a junction box (not shown) for the connection with an external circuit is provided to an outer side surface of the substrate 2, and a module frame is provided to a peripheral end surface of the photoelectric conversion module with interposition of an adhesive sealing material in order that the impact strength of the photoelectric conversion module can be easily improved and the photoelectric conversion module can be easily installed in a building and the like. Thus, the photoelectric conversion module can be prepared.

In the photoelectric conversion module X1, preferably, as shown in FIG. 3, a plurality of photoelectric conversion layers (in FIG. 3, the photoelectric conversion layer is a laminated body including the chalcopyrite-based compound semiconductor layer 4 and the buffer layer 5) are arranged at intervals, and the protective member 9 is loaded in the intervals. Such a structure causes an anchor effect which enables the protective member 9 to be firmly in close contact with the photoelectric conversion element D1 so that peel-off does not easily occur.

It is preferable that the photoelectric conversion layer includes a compound semiconductor containing a hydroxyl group. In this configuration, in a case where a surface of the photoelectric conversion layer comes into contact with the protective member 9, a hydrogen bonding between the hydroxyl group of the photoelectric conversion layer and the EVA contained in the protective member 9 or a hydrogen bonding between the hydroxyl group of the photoelectric conversion layer and the acid acceptor contained in the protective member 9 brings the protective member 9 and the photoelectric conversion layer into good contact with each other, thus improving the effect of sealing to the photoelectric conversion layer. Here, the case where the surface of the photoelectric conversion layer comes into contact with the protective member 9 means, for example, a case where a side surface of the photoelectric conversion layer is in contact with the protective member 9 as shown in FIG. 3, or the case where a pinhole is formed in the light-transmitting conductive layer 6 placed on the photoelectric conversion layer so that the protective member 9 entering the pinhole is in contact with the photoelectric conversion layer.

In the photoelectric conversion layer including the compound semiconductor containing the hydroxyl group, if the photoelectric conversion layer is a laminated body including the chalcopyrite-based compound semiconductor layer 4 and the buffer layer 5, a layer including a compound semiconductor containing a hydroxide is adoptable as the buffer layer 5, for example. Such a buffer layer 5 can be formed by, for example, mixing indium hydroxide or zinc hydroxide into indium sulfide or zinc sulfide in an aqueous solution containing the materials of the buffer layer 5 during the process for forming the buffer layer 5 in which indium sulfide or zinc sulfide is deposited on the surface of the chalcopyrite-based compound semiconductor layer 4. The amount of such a metal hydroxide mixed can be adjusted by controlling the pH or temperature of the aqueous solution.

Preferably, such a compound semiconductor containing metal sulfide and metal hydroxide is additionally heat-treated at 50 to 300 degrees C for 5 to 120 minutes, to change a part of the metal hydroxide into a metal oxide, thus forming a mixed crystal compound semiconductor containing a metal sulfide, a metal oxide, and a metal hydroxide. This can make a better hetero junction with the photoelectric conversion layer while maintaining a good sealing property. Therefore, the photoelectric conversion efficiency can be improved.

In a case where the photoelectric conversion layer includes a compound semiconductor containing a hydroxyl group, the acid acceptor preferably contains a metal hydroxide. This results in a firmer hydrogen bonding between the acid acceptor and the hydroxyl group of the photoelectric conversion layer.

An anti-reflection layer may be formed at the interface between the light-transmitting conductive layer 6 and the protective member 9, in order to suppress reflection of a light incident on the photoelectric conversion layer. In this case, it is preferable that silicone nitride or a fluorine compound is used for the anti-reflection layer. As a result, a hydrogen bonding between the anti-reflection layer and the EVA contained in the protective member 9 or a hydrogen bonding between the anti-reflection layer and the acid acceptor contained in the protective member 9 brings the protective member 9 and the anti-reflection layer into good contact with each other, thus improving the sealing effect.

Next, the photoelectric conversion module according to the second embodiment of the present invention will be described. As shown in FIG. 4, a photoelectric conversion module X2 according to the second embodiment is identical to the photoelectric conversion module X1 according to the first embodiment except that the photoelectric conversion element D1 is replaced with a photoelectric conversion element D2. Except for the photoelectric conversion element D2, the same members as those of the photoelectric conversion module X1 described above may be used. Such a configuration can also reduce the influence of the acid material on the light-transmitting conductive layer 6, similarly to the photoelectric conversion module X1 according to the first embodiment.

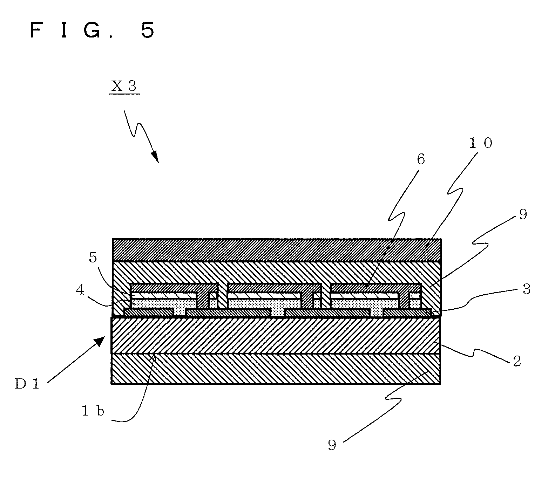

Next, a photoelectric conversion module according to a third embodiment of the present invention will be described. As shown in FIG. 5, in a photoelectric conversion module X3 according to the third embodiment, the protective member 9 is arranged so as to also cover the second main surface 1b (lower surface of the photoelectric conversion element 1) of the photoelectric conversion element D1 to protect the photoelectric conversion element D1 from the second main surface 1b side, too. Such a configuration enables the protective member 9 to cover the surface side and the back surface side of the photoelectric conversion element D1. This improves the function of protecting the photoelectric conversion element D1, and additionally allows the substrate 2 to be made of a material easily corroded by an acid material, which increases the degree of freedom of the material of the substrate 2.

Next, a photoelectric conversion module according to a fourth embodiment of the present invention will be described.

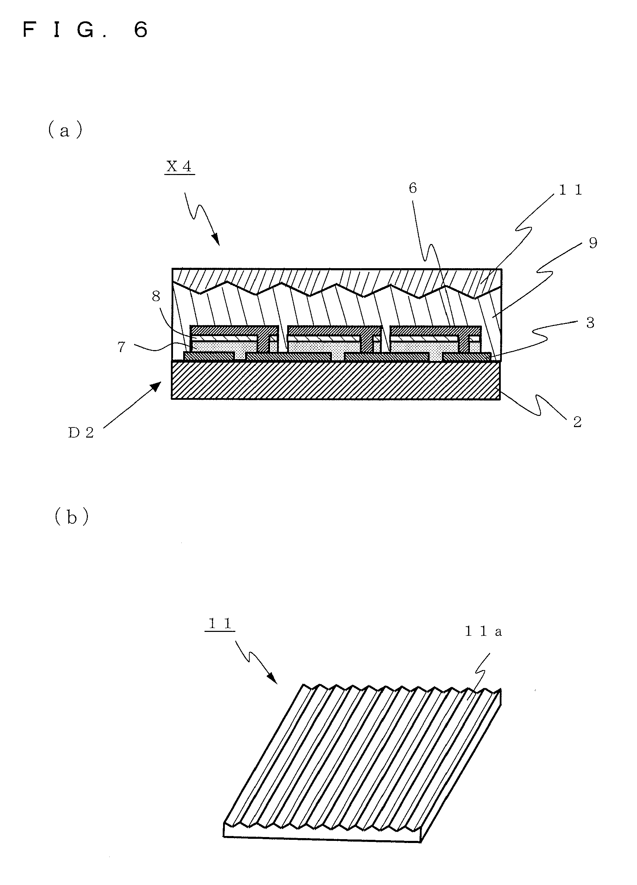

As shown in FIG. 6, a photoelectric conversion module X4 according to the fourth embodiment is different from the photoelectric conversion module X1 according to the first embodiment described above, in that the photoelectric conversion element D2 is provided instead of the photoelectric conversion element D1 of the photoelectric conversion module X1 and that a covering member 11 having an uneven surface facing the photoelectric conversion element D2 is provided instead of the covering member 10 having a flat plate shape.

The covering member 11 has a function of reflecting a light at an uneven surface 11a. More specifically, even if a light incident from a lower surface of the substrate 2 is transmitted through the photoelectric conversion element D2, the light is reflected by the uneven surface 11 a of the covering member 11 and thus can be incident on the amorphous silicon semiconductor layer 7 and the microcrystalline silicon semiconductor layer 8 again. Therefore, in this embodiment, the photoelectric conversion efficiency can be improved.

A material capable of efficient light reflection suffices as the material of the covering member 11. Examples thereof include a white polycarbonate plate having a high weather resistance and having a thickness of approximately 3 to 6 mm, EVA having a white pigment added thereto, a white PET (polyethylene terephthalate) resin, or a white fluorine resin sheet. The uneven surface 11a is formed by machining or blasting a flat-shaped polycarbonate plate or by a transfer process using a mold having an uneven surface, for example.

The uneven surface 11a of the covering member 11 may have any shape as long as the shape allows an efficient reflection in a direction different from a light incident direction. For example, a V-like shape may be mentioned, as shown in FIG. 5(b). In the uneven shape having such V-like grooves, it is desirable that the V-like groove forms an angle of 40 to 90° or an angle of 115° or more. Moreover, it is preferable that the grooves have a pitch of 2 µm or more and 10 mm or less, in view of efficiently reflecting even a long-wavelength light in a direction different from the incident direction.

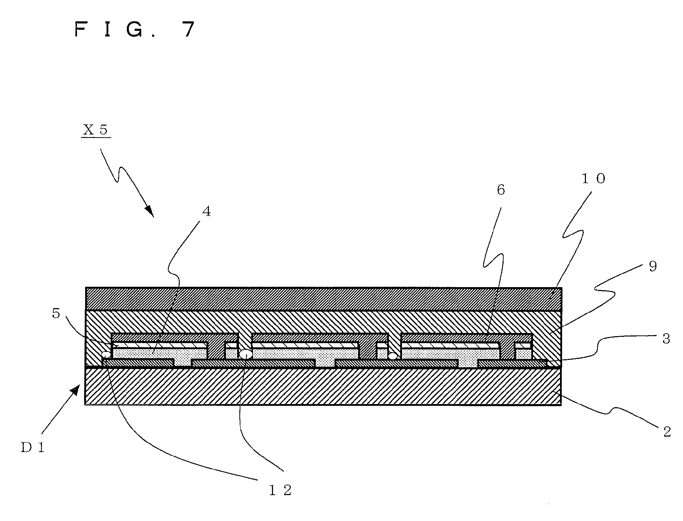

Next, a photoelectric conversion module according to a fifth embodiment of the present invention will be described. As shown in FIG. 7, a photoelectric conversion module X5 according to the fifth embodiment of the present invention is identical to the photoelectric conversion module X1 according to the first embodiment, except that a plurality of air bubbles 12 are provided at the interface between the protective member 9 and the electrodes 3. In this configuration, even if the EVA contained in the protective member 9 is hydrolyzed to cause acid, the air bubble 12 can prevent the acid from reaching the electrodes 3, and thus can suppress corrosion of the electrodes 3. Particularly when the air bubble 12 is provided at the corner formed by the photoelectric conversion layer and the electrode 3, an entry of the acid into the interface having a relatively small adhesivity between the photoelectric conversion layer and the electrode 3 can be effectively suppressed, so that the photoelectric conversion efficiency can be maintained in a good state.

If the protective member 9 contains EVA, the air bubbles 12 in the protective member 9 can be prepared by causing the EVA to foam by raising the temperature during the lamination process performed in the step of preparing the photoelectric conversion module X1. For example, in a case where the photoelectric conversion module X1 is prepared using EVA that hardly foams if a peak temperature in the lamination process is approximately 100 to 130 degrees C, the peak temperature in the lamination process is raised to approximately 140 to 160 degrees C, thereby causing the EVA to foam. Thus, a plurality of air bubbles 12 can be prepared at the interface between the protective member 9 and the electrode 3.

### DESCRIPTION OF THE REFERENCE NUMERALS

X1 to X5; photoelectric conversion module
D1, D2; photoelectric conversion element
2; substrate
3; electrode
4; chalcopyrite-based compound semiconductor layer
5; buffer layer
6; light-transmitting conductive layer
7; amorphous silicon semiconductor layer
8; microcrystalline-silicon-based semiconductor layer
9; protective member
10, 11; covering member
12; air bubble

## Claims

1. A photoelectric conversion module comprising:
a photoelectric conversion element comprising at least one photoelectric conversion layer with a first main surface and a light-transmitting conductive layer located on the first main surface; and
a protective member on the light-transmitting conductive layer comprising an ethylene vinyl acetate resin and an acid acceptor.

2. The photoelectric conversion module according to claim 1, wherein
the at least one photoelectric conversion layer comprises a plurality of photoelectric conversion layers, and the plurality of photoelectric conversion layers are arranged at intervals with the protective member being located in the intervals.

3. The photoelectric conversion module according to claim 1, wherein
the at least one photoelectric conversion layer comprises a compound semiconductor containing a hydroxyl group.

4. The photoelectric conversion module according to claim 3, wherein
the compound semiconductor comprises a mixed crystal compound semiconductor obtained by mix-crystallization of a metal sulfide, a metal oxide, and a metal hydroxide.

5. The photoelectric conversion module according to claim 3, wherein
the acid acceptor comprises a second metal hydroxide.

6. The photoelectric conversion module according to claim 5, wherein
the second metal hydroxide comprises magnesium hydroxide.

7. The photoelectric conversion module according to claim 1, wherein
the light-transmitting conductive layer comprises zinc oxide.

8. The photoelectric conversion module according to claim 1, wherein
the light-transmitting conductive layer comprises indium tin oxide.

9. The photoelectric conversion module according to claim 1, wherein
the at least one photoelectric conversion layer comprises a chalcopyrite-based compound.

10. The photoelectric conversion module according to claim 1, wherein
the at least one photoelectric conversion layer comprises an amorphous-silicon-based thin film.

11. The photoelectric conversion module according to claim 1, wherein
the photoelectric conversion element comprises a second main surface serving as a back surface relative to the first main surface,
the protective member is located further on the second main surface of the photoelectric conversion element.

12. The photoelectric conversion module according to claim 1, wherein
the photoelectric conversion element comprises a second main surface serving as a back surface relative to the first main surface,
an electrode is located on the second main surface, and a plurality of air bubbles are provided at an interface between the electrode and the protective member.
